# EUROPÄISCHE PATENTSCHRIFT

(11) **EP 1 166 357 B1**
(45) Veröffentlichungstag und Bekanntmachung des Hinweises auf die Patenterteilung: **10.05.2006**
(21) Anmeldenummer: 99971967.7
(22) Anmeldetag: 23.09.1999
(51) Int. Cl.: H01L 27/115

(54) **SPEICHERZELLENANORDNUNG**
MEMORY CELL ARRANGEMENT
DISPOSITIF DE CELLULES DE MEMOIRE

(30) Priorität: 10.11.1998 DE 19851866
(43) Veröffentlichungstag der Anmeldung: 02.01.2002
(73) Patentinhaber: Infineon Technologies AG, 81669 München (DE)
(72) Erfinder: SCHLÖSSER, Till, D-01109 Dresden (DE); KRAUTSCHNEIDER, Wolfgang, D-21149 Hamburg (DE); HOFMANN, Franz, D-80995 München (DE); HANEDER, Thomas-Peter, D-81549 München (DE)
(74) Vertreter: Epping - Hermann - Fischer
(86) Internationale Anmeldenummer: PCT/DE1999/003044
(87) Internationale Veröffentlichungsnummer: WO 2000/028596

(56) Entgegenhaltungen:
- EP-A- 0 516 031
- US-A- 5 300 799
- US-A- 5 345 415
- US-A- 5 689 456
- US-A- 5 708 284
- US-A- 5 753 946
- PATENT ABSTRACTS OF JAPAN vol. 1996, no. 08, 30. August 1996 (1996-08-30) -& JP 08 097386 A (NEC CORP), 12. April 1996 (1996-04-12)
- PATENT ABSTRACTS OF JAPAN vol. 1999, no. 10, 31. August 1999 (1999-08-31) & JP 11 135737 A (INTERNATL BUSINESS MACH CORP <IBM>), 21. Mai 1999 (1999-05-21)
- PATENT ABSTRACTS OF JAPAN vol. 018, no. 187 (P-1720), 30. März 1994 (1994-03-30) -& JP 05 342850 A (ROHM CO LTD), 24. Dezember 1993 (1993-12-24)

## Beschreibung

Die Erfindung betrifft eine Speicherzellenanordnung zur nichtflüchtigen Speicherung von Daten.

Zur nichtflüchtigen Speicherung von Daten werden vielfach Speicherzellenanordnungen verwendet, bei denen die Speicherzelle jeweils einen konventionellen MOS-Transistor enthält, der neben einem Steuergate ein Floatinggate aufweist. Auf dem Floatinggate sind Ladungen gespeichert, die der zu speichernden Information entsprechen (siehe S. M. Sze, Semiconductor Devices, J. Wiley 1985, Seite 490). Derartige Speicherzellen werden auch als EEPROM-Zellen bezeichnet. Sie können elektrisch programmiert werden. Allerdings sind zum Einschreiben von Daten Zeitkonstanten von bis zu 20 ms erforderlich. Diese Speicher lassen sich nur beschränkt umprogrammieren, das heißt etwa 10⁶ Zyklen.

Ferner sind Speicherzellen bekannt (siehe H. N. Lee et al, Ext. Abstr. Int. Conf. Solid State Devices and Materials, 1997, Seiten 382 bis 383), in denen zur nichtflüchtigen Speicherung von Daten Speicherzellen mit jeweils einem ferroelektrischen Feldeffekttransistor vorgesehen sind. Der ferroelektrische Transistor weist wie ein MIS-Transistor Source, Drain, Gatedielektrikum und Gateelektrode auf, wobei das Gatedielektrikum eine ferroelektrische Schicht enthält. Die ferroelektrische Schicht kann zwei unterschiedliche Polarisationszustände einnehmen, die den logischen Werten einer digitalen Information zugeordnet werden. Durch Anlegen einer ausreichend hohen Spannung wird der Polarisationszustand der ferroelektrischen Schicht verändert. Bei Integration des ferroelektrischen Transistors in eine Siliziumprozeßtechnik wird zwischen die Oberfläche eines Siliziumsubstrats und die ferroelektrische Schicht eine dielektrische Zwischenschicht eingebracht, die die Grenzflächeneigenschaften sicherstellt.

Beim Programmieren der Speicherzelle fällt ein Teil der zwischen Siliziumsubstrat und Gateelektrode angelegten Spannung über die Zwischenschicht ab.

Um die technologischen Schwierigkeiten der Grenzflächen zu vermeiden, wurde vorgeschlagen (Y. Katoh et al, Symp. VLSI Technol., 1996, Seiten 56 bis 57), als Speicherzelle einen MOS-Transistor zu verwenden, dessen Gateelektrode mit einem ferroelektrischen Kondensator in Reihe geschaltet ist. In dieser Speicherzelle liegt an der Gateelektrode eine vom Polarisationszustand der ferroelektrischen Schicht des ferroelektrischen Kondensators abhängige Spannung an. In dieser Speicherzelle ist es erforderlich, daß die Verbindung zwischen der Gateelektrode und dem ferroelektrischen Kondensator keinen Ladungsfluß erlaubt, da andernfalls die gespeicherte Information verlorengeht und die Zeit für den Datenerhalt zur nichtflüchtigen Speicherung nicht ausreicht.

Der Erfindung liegt die Aufgabe zugrunde, eine Speicherzellenanordnung anzugeben, die zur nichtflüchtigen Speicherung von Daten geeignet ist, die häufiger als EEPROM-Anordnungen umprogrammierbar ist und in der die Zeit für den Datenerhalt unabhängig von Leckströmen ist.

Diese Aufgabe wird gelöst durch eine Speicherzellenanordnung gemäß Anspruch 1. Weitere Ausgestaltungen der Erfindung gehen aus den übrigen Ansprüchen hervor.

Die Speicherzellenanordnung weist in einem Halbleitersubstrat integriert eine Vielzahl Speicherzellen auf, die jeweils einen Auswahltransistor, einen Speichertransistor und einen ferroelektrischen Kondensator aufweisen. Der Auswahltransistor und der Speichertransistor sind in Reihe verschaltet. Der ferroelektrische Kondensator ist zwischen einen ersten Anschluß des Auswahltransistors, der mit einem zweiten Anschluß des Speichertransistors verbunden ist, und eine Steuerelektrode des Speichertransistors geschaltet.

Die Speicherzelle ist jeweils über eine Wortleitung, über die der Auswahltransistor eingeschaltet wird, ansteuerbar. Ist der Auswahltransistor eingeschaltet, so liegt das am Auswahltransistor anliegende Potential direkt am Speichertransistor und an den ferroelektrischen Kondensator an. Abhängig von der Polarisation der ferroelektrischen Schicht des ferroelektrischen Kondensators wird dann der Speichertransistor eingeschaltet bzw. nicht eingeschaltet. Der Pegel des Signals, das zu detektieren ist, hängt von dem Pegel ab, der am Auswahltransistor anliegt. Die Speicherzelle ist somit nach Art einer selbstverstärkenden Speicherzelle aufgebaut.

Die Information wird in Form der Polarisation der ferroelektrischen Schicht eingespeichert. Die Polarisation läßt sich beliebig oft umschalten. Wird eine Speicherzelle durch Ansteuerung der entsprechenden Wortleitung ausgewählt, so liegt über den Auswahltransistor ein festes Potential an dem ferroelektrischen Kondensator an. Entsprechend der Polarisation der ferroelektrischen Schicht liegt an der Gateelektrode des Speichertransistors eine von der gespeicherten Information abhängige Spannung an. Ist die Speicherzelle dagegen nicht ausgewählt, so kann das Potential über eventuelle Leckströme über den ersten Anschluß des Auswahltransistors ins Gleichgewicht relaxieren. Die Information geht dabei nicht verloren. Erst über das Öffnen des Auswahltransistors wird der ferroelektrische Kondensator wieder mit einem definierten Potential beaufschlagt und es liegt am Speichertransistor wieder eine Spannung an.

Vorzugsweise werden für den Auswahltransistor und den Speichertransistor jeweils MOS-Transistoren verwendet. Die Steuerelektrode des Speichertransistors ist dann eine Gateelektrode. Der Auswahltransistor ist über seine Gateelektrode mit einer Wortleitung verbunden. Auswahltransistor und Speichertransistor sind in Reihe zwischen eine Bitleitung und eine Referenzleitung geschaltet. Die Referenzleitung und die Bitleitung verlaufen parallel. Ob eine dieser Leitungen als Bitleitung oder als Referenzleitung verwendet wird, wird durch die Beschaltung definiert.

Der ferroelektrische Kondensator weist eine ferroelektrische Schicht auf, die zwischen zwei Kondensatorelektroden angeordnet ist.

Zum Einschreiben von Information in diese Speicherzelle wird zwischen die Bitleitung und die Referenzleitung eine erhöhte Spannung angelegt, so daß die Polarisation der ferroelektrischen Schicht verändert wird. Dabei ist es vorteilhaft, das Verhältnis der Kapazitäten des ferroelektrischen Kondensators und der Gateelektrode des Speichertransistors ungefähr auf 1:1 einzustellen. Da die Dielektrizitätskonstante der ferroelektrischen Schicht (zum Beispiel SBT = Strontium-Bismut-Tantalat) des ferroelektrischen Kondensators zu der dielektrischen Schicht des Transistors (zum Beispiel SiO₂ in der Standard-Silizium-Prozeßtechnologie) etwa in einem Verhältnis von 100 zu 1 steht, erhält man bei gleicher Fläche von Kondensator und Transistor-Gate einen Spannungsteiler mit sehr ungünstigen Bedingungen. Vorzugsweise sollen aber die Flächenanteile beider Bauteile möglichst gering und damit etwa gleich sein. Es gibt mehrere Möglichkeiten, das Kapazitätsverhältnis des Spannungsteilers dennoch zu verbessern. Die Dielektrizitätskonstante der ferroelektrischen Schicht kann durch geeignete Wahl der Abscheidebedingungen, zum Beispiel eines geringeren Temperaturbudgets, oder im Fall von SBT durch Beifügen geringer Mengen Niob reduziert werden. Damit sinkt die Kapazität des ferroelektrischen Kondensators.

Andererseits ist es im Bereich des Transistors möglich, die Gate-Kapazität zu erhöhen, indem man zum Beispiel CeO₂, ZrO₂ oder ein sehr dünnes nitridiertes Silizium-Oxid als GateDielektrikum für den Transistor verwendet. Damit kann erreicht werden, daß die Gate-Kapazität des Transistors im Vergleich zu herkömmlichem SiO₂ bei vergleichbarer Schichtdicke erheblich zunimmt (für CeO₂ zum Beispiel um einen Faktor 5).

Darüber hinaus können die Kapazitäten geeignet aufeinander abgestimmt werden, indem die Schichtdicke der ferroelektrischen Schicht des ferroelektrischen Kondensators zum Beispiel um einen Faktor 50 über der der dielektrischen Schicht des Transistors liegt.

Zur Vergrößerung der Kapazität zwischen der Gateelektrode und dem Kanalgebiet des Speichertransistors ist es vorteilhaft, eines der Source-/Drain-Gebiete des Speichertransistors so zu entwerfen, daß es mit der Gateelektrode des Speichertransistors überlappt. Der Überlapp zwischen dem ersten Source-/Drain-Gebiet und der Gateelektrode des Speichertransistors beträgt dabei mindestens 10 Prozent der Fläche der Gateelektrode.

Vorzugsweise ist der Speichertransistor über einen ersten Anschluß mit der Referenzleitung verbunden und es ist zwischen die Gateelektrode des Speichertransistors und die Referenzleitung ein Widerstand geschaltet. In dieser Anordnung sind der Lesevorgang und der Schreib-/Lesespeicherschreibvorgang in der Zeitskala getrennt. Zum Lesen der Information wird die Speicherzelle ausgewählt und es liegt für eine Zeit, die vom Widerstand und der Kapazität des ferroelektrischen Kondensators abhängt, eine Spannung an der Gateelektrode des Speichertransistors an. Während dieser Zeit kann die Information ausgelesen werden. Nach Ablauf dieser Zeit liegt die Spannung direkt am ferroelektrischen Kondensator an, so daß die Polarisation der ferroelektrischen Schicht verändert werden kann. Als Widerstand ist in dieser Ausgestaltung jeder Widerstand geeignet. Er kann eine ohmsche Kennlinie aufweisen. Es sind jedoch auch Widerstände ohne ohmsche Kennlinie geeignet. Insbesondere kann der Widerstand durch eine dünne dielektrische Schicht realisiert werden, die durch Tunneln von Ladungsträgern durchflossen wird. Derartige Widerstände werden auch als Tunnelwiderstand bezeichnet. In dieser Ausgestaltung wird die Referenzleitung mit 0 Volt, die Bitleitung mit einer Versorgungsspannung verbunden. Die Zeitkonstante ist über den Widerstand und die Kapazität einstellbar.

Als Halbleitersubstrat ist insbesondere ein Substrat, das monokristallines Silizium enthält, insbesondere eine monokristalline Siliziumscheibe, ein SOI-Substrat oder SiC-Substrat geeignet.

Für die ferroelektrische Schicht des ferroelektrischen Kondensators sind unter anderem Strontium-Wismut-Tantalat (SBT), Blei-Zirkonium-Titanat (PZT), Lithium-Niobat (LiNbO₃) oder Barium-Strontium-Titanat (BST) einsetzbar.

Im folgenden wird die Erfindung anhand von Ausführungsbeispielen, die in den Figuren dargestellt sind, näher erläutert.
- Figur 1: zeigt eine Speicherzelle, die einen Auswahltransistor, einen Speichertransistor und einen ferroelektrischen Kondensator aufweist.
- Figur 2: zeigt eine technologische Ausführungsform für die in Figur 1 dargestellte Speicherzelle.
- Figur 3: zeigt eine Speicherzelle, die einen Auswahltransistor, einen Speichertransistor, einen ferroelektrischen Kondensator und einen Widerstand aufweist.

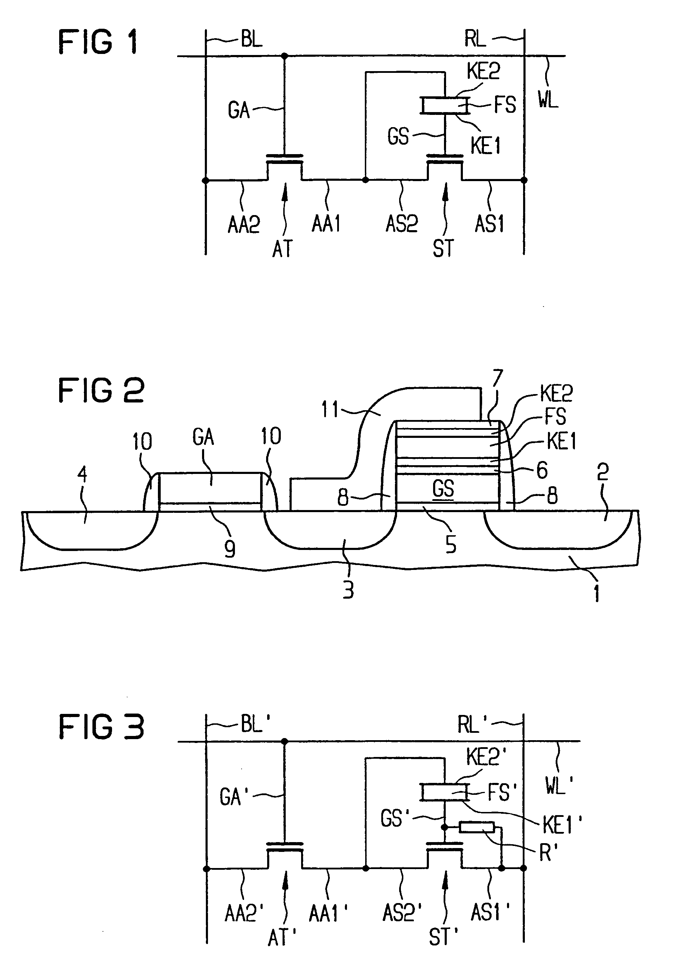

Ein erster Anschluß AS1 eines Speichertransistors ST ist mit einer Referenzleitung RL verbunden (siehe Figur 1). Ein zweiter Anschluß AS2 des Speichertransistors ST ist mit einem ersten Anschluß AA1 eines Auswahltransistors AT verbunden. Ein zweiter Anschluß des Auswahltransistors AA2 ist mit einer Bitleitung BL verbunden. Eine Gateelektrode GA des Auswahltransistors AT ist mit einer Wortleitung WL verbunden. Eine Gateelektrode GS des Speichertransistors ST ist mit einer ersten Kondensatorelektrode KE1 eines ferroelektrischen Kondensators verbunden. Der ferroelektrische Kondensator umfaßt neben der ersten Kondensatorelektrode KE1 eine ferroelektrische Schicht FS und eine zweite Kondensatorelektrode KE2, die mit dem ersten Anschluß AA1 des Auswahltransistors AT verbunden ist.

Zum Betrieb der aus dem Auswahltransistor AT, dem Speichertransistor ST und dem ferroelektrischen Kondensator gebildeten Speicherzelle wird zum Lesen von Daten zwischen die Bitleitung BL und die Referenzleitung RL eine Spannung angelegt. Über die Wortleitung WL wird der Auswahltransistor AT eingeschaltet. Damit liegt das an der Bitleitung anliegende Potential an dem zweiten Anschluß AS2 des Speichertransistors ST und an der zweiten Kondenstorelektrode KE2 an. Das an der Gateelektrode GS des Speichertransistors ST anliegende Potential hängt ab von der Polarisation der ferroelektrischen Schicht FS. Zum Auslesen der Information, die der Polarisation der ferroelektrischen Schicht FS zuzuordnen ist, wird bewertet, ob zwischen der Bitleitung BL und der Referenzleitung RL ein Strom fließt oder nicht. Zum Lesen von Information werden an die Bitleitung BL, die Referenzleitung RL und die Wortleitung WL folgende Pegel angelegt: Referenzleitung RL: V_{dd}/O, Bitleitung BL: O/V_{dd}, Wortleitung WL: V_{dd} + Vₜ. Dabei ist V_{dd} die Versorgungsspannung und Vₜ die Schwellenspannung des Auswahltransistors. Die Erhöhung der an der Wortleitung anliegenden Spannung um Vₜ wird allgemein als Boost bezeichnet.

Zum Speichern von Information in dieser Speicherzelle wird zwischen Bitleitung BL und Referenzleitung RL eine höhere Spannung angelegt, so daß über den ferroelektrischen Kondensator bei eingeschaltetem Auswahltransistor AT eine zur Änderung der Polarisationsrichtung der ferroelektrischen Schicht FS ausreichende Spannung anliegt.

Zum Speichern von Information in der Speicherzelle werden folgende Pegel angelegt: Bitleitung BL: O bzw. V_{dd}, Referenzleitung RL: 2 V_{dd} bzw. - V_{dd}, Wortleitung WL: V_{dd} bzw. V_{dd} + Vₜ. Dabei wird angenommen, daß die Kapazität des ferroelektrischen Kondensators beispielsweise 5 fF/µm², die Kapazität der Gateelektrode GS des Speichertransistors zum Beispiel 5 fF/µm² beträgt.

Um eine negative Spannung an der Referenzleitung RL anlegen zu können, müssen sich die mit der Referenzleitung RL verbundenen Bereiche 2 innerhalb einer Wanne befinden, die mit einer negativen Spannung beaufschlagt wird, die etwa gleich der negativen Spannung an der Referenzleitung RL ist. Diese Wanne besteht aus halbleitendem Material mit einem Dotierungstyp, der entgegengesetzt zu dem Dotierungstyp des ersten Source-/Draingebietes 2 ist. Bei der für Speicherzellen vorherrschenden n-Kanal MOS-Technik ist das erste Source-/Draingebiet 2 vom n-Typ, die Wanne ist dann vom p-Typ dotiert.

Eine andere Möglichkeit, die notwendige Umkehr des elektrischen Feldes über dem ferroelektrischen Material beim Programmieren der logischen Zustände zu erreichen, besteht darin, an der Referenzleitung eine Spannung von 2 V_{dd} bzw. 0 V und an der Bitleitung 0 bzw. 2 V_{dd} anzulegen. Dies bedeutet, daß im Falle einer Spannung von 2 V_{dd} an der Bitleitung das Gateoxid des Auswahltransistors AT mit einer Dicke ausgeführt werden muß, die für eine Spannung 2 V_{dd} + Vₜ an der Wortleitung WL ausgelegt ist, damit die Spannung 2 V_{dd} von der Bitleitung zu dem ferroelektrischen Kondensator durchgeschaltet werden kann. Vₜ bezeichnet die Schwellenspannung des Auswahltransistors AT.

Die Speicherzelle ist in einem Halbleitersubstrat 1 aus monokristallinem Silizium realisiert (siehe Figur 2). In dem Halbleitersubstrat 1 sind ein erstes Source-/Drain-Gebiet 2, ein gemeinsames Source-/Drain-Gebiet 3 und ein zweites Source-/Drain-Gebiet 4 vorgesehen. Zwischen dem ersten Source-/Drain-Gebiet 2 und dem gemeinsamen Source-/Drain-Gebiet 3 sind an der Oberfläche des Halbleitersubstrats 1 ein erstes Gateoxid 5 und die Gateelektrode GS des Speichertransistors ST angeordnet. Das Gateoxid 5 weist eine Dicke von 4 bis 12 nm auf. Die Gateelektrode GS des Speichertransistors ST enthält n-dotiertes Polysilizium mit einer Dotierstoffkonzentration von > 10²⁰ cm⁻³ und einer Dicke von 100 bis 300 nm. An der Oberfläche der Gateelektrode GS ist eine erste Barriereschicht 6 zum Beispiel aus TiN in einer Dicke von 10 bis 50 nm angeordnet, auf der die erste Kondensatorelektrode KE1 aus Platin in einer Dicke von 20 bis 200 nm angeordnet ist. Die erste Kondensatorelektrode KE1 grenzt an die ferroelektrische Schicht FS aus Strontium-Wismut-Tantalat (SBT) oder Blei-Zirkonium-Titanat (PZT) an, die eine Dicke von 20 bis 200 nm aufweist. Auf der der ersten Kondensatorelektrode KE1 abgewandten Seite der ferroelektrischen Schicht FS ist die zweite Kondensatorelektrode KE2 aus Platin in einer Dicke von 20 bis 200 nm angeordnet. Die zweite Kondensatorelektrode KE2 ist mit einer zweiten Barriereschicht 7 aus TiN mit einer Dicke von 10 bis 50 nm versehen.

Das erste Gateoxid 5, die Gateelektrode GS des Speichertransistors ST, die erste Barriereschicht 6, die erste Kondensatorelektrode KE1, die ferroelektrische Schicht FS, die zweite Kondensatorelektrode KE2 und die zweite Barriereschicht 7 weisen gemeinsame Flanken auf, die mit isolierenden Spacern 8 aus SiO₂ versehen sind.

Zwischen dem gemeinsamen Source-/Drain-Gebiet 3 und dem zweiten Source-/Drain-Gebiet 4 ist an der Oberfläche des Halbleitersubstrats 1 ein zweites Gateoxid 9 in einer Dicke von 4 bis 12 nm und die Gateelektrode GA des Auswahltransistors AT angeordnet. Die Gateelektrode GA des Auswahltransistors AT und das zweite Gateoxid 9 weisen gemeinsame Flanken auf, die mit isolierenden Spacern 10 aus SiO₂ versehen sind.

Eine leitende Verbindung 11 aus dotiertem Polysilizium reicht von der Oberfläche des gemeinsamen Source-/Drain-Gebietes 3 bis auf die Oberfläche der zweiten Barriereschicht 7. Über die leitende Verbindung 11 sind die zweite Kondensatorelektrode KE2 und das gemeinsame Source-/Drain-Gebiet 3 miteinander elektrisch verbunden.

Im ausgeschalteten Zustand des Auswahltransistors AT kann sich ein an der zweiten Kondensatorelektrode KE2 anliegendes Potential über das gemeinsame Source-/Drain-Gebiet 3 relaxieren. Beim Einschalten des Auswahltransistors AT wird das gemeinsame Source-/Drain-Gebiet 3 wieder auf das durch die Bitleitung BL vorgegebene Potential gezogen. Daher geht die Information in dieser Speicherzelle nicht verloren, selbst wenn über die Verbindung zwischen der Gateelektrode GS des Speichertransistors ST und der ersten Kondensatorelektrode KE1 ein Ladungfluß über Leckströme auftritt.

In einem weiteren Ausführungsbeispiel sind ein Speichertransistor ST' und ein Auswahltransistor AT' in Reihe zwischen eine Referenzleitung RL' und eine Bitleitung BL' geschaltet. Dabei ist ein erster Anschluß AS1' des Speichertransistors ST' mit der Referenzleitung RL', ein zweiter Anschluß AS2' des Speichertransistors ST' mit einem ersten Anschluß AA1' des Auswahltransistors AT' und ein zweiter Anschluß AA2' des Auswahltransistors AT' mit der Bitleitung BL' verbunden. Die Gateelektrode GA' des Auswahltransistors AT' ist mit einer Wortleitung WL' verbunden.

Die Speicherzelle weist darüber hinaus einen ferroelektrischen Kondensator auf, der eine erste Kondensatorelektrode KE1', eine ferroelektrische Schicht FS' und eine zweite Kondensatorelektrode KE2' umfaßt. Die erste Kondensatorelektrode KE1' ist mit einer Gateelektrode GS' des Speichertransistors ST' verbunden. Die zweite Kondensatorelektrode KE2' ist mit dem ersten Anschluß AA1' des Auswahltransistors AT' verbunden. Zwischen die Gateelektrode GS' des Speichertransistors ST' und den ersten Anschluß AS1' des Speichertransistors ST' ist ein Widerstand R' geschaltet, der einen Widerstandswert R aufweist.

Beim Betrieb der Speicherzelle erfolgt die Auswahl der Speicherzelle über die Wortleitung WL' und die Gateelektrode GA' des Auswahltransistors AT'. Durch Einschalten des Auswahltransistors AT' liegt zwischen dem ersten Anschluß AS1' und dem zweiten Anschluß AS2' des Speichertransistors ST' die zwischen der Wortleitung WL' und der Referenzleitung RL' angelegte Spannung an. Die Bitleitung BL' wird dabei mit einer Versorgungsspannung VDD von 1,5 bis 3,3 V, die Referenzleitung RL' mit 0 Volt beaufschlagt.

Während einer Zeit von etwa RC, wobei R der Widerstandswert des Widerstands R' und C die Kapazität von 1 bis 3 fF ist, liegt an der Gateelektrode GS' des Speichertransistors S' eine Spannung an, die von der Versorgungsspannung VDD am zweiten Anschluß AS2' des Speichertransistors ST' und der Polarisation der ferroelektrischen Schicht FS' abhängt. Nach einer längeren Zeit fließen Oberflächenladungen der ferroelektrischen Schicht FS' über den Widerstand R' ab, so daß die Versorgungsspannung über dem ferroelektrischen Kondensator abfällt. Bei Zeiten, die länger als RC sind, liegt daher eine Spannung an dem ferroelektrischen Kondensator an, die zum Schreiben, das heißt zur Veränderung der Polarisation der ferroelektrischen Schicht FS' verwendet wird.

Die Zeitkonstante RC beträgt 10 bis 50 ns.

## Patentansprüche

1. Speicherzellenanordnung,
- bei der in einem Halbleitersubstrat (1) integriert eine Vielzahl Speicherzellen vorgesehen sind, die jeweils einen Auswahltransistor (AT), einen Speichertransistor (ST) und einen ferroelektrischen Kondensator (KE1, FS, KE2) aufweisen,
- bei der der Auswahltransistor (AT) und der Speichertransistor (ST) über einen ersten Anschluß (AA1) des Auswahltransistors (AT) in Reihe verschaltet sind,
- bei der der ferroelektrische Kondensator (KE1, FS, KE2) zwischen den ersten Anschluß (AA1) des Auswahltransistors (AT) und eine Steuerelektrode (GS) des Speichertransistors (ST) geschaltet ist.

2. Speicherzellenanordnung nach Anspruch 1,
- bei der der Auswahltransistor (AT) und der Speichertransistor (ST) jeweils als MOS-Transistor ausgebildet sind,
- bei der eine Gateelektrode (GA) des Auswahltransistors (AT) mit einer Wortleitung (WL) verbunden ist,
- bei der der Auswahltransistor (AT) und der Speichertransistor (ST) in Reihe zwischen eine Bitleitung (BL) und eine Referenzleitung (RL) geschaltet sind.

3. Speicherzellenanordnung nach Anspruch 2,
- bei der der Speichertransistor (ST) über einen ersten Anschluß (AS1) mit der Referenzleitung (RL) verbunden ist,
- bei der zwischen die Steuerelektrode (GS') des Speichertransistors (ST') und die Referenzleitung (RL') ein Widerstand (R') geschaltet ist.

4. Speicherzellenanordnung nach einem der Ansprüche 1 bis 3,
- bei der der ferroelektrische Kondensator eine erste Elektrode (KE1), eine ferroelektrische Schicht (FS) und eine zweite Elektrode (KE2) aufweist,
- bei der die ferroelektrische Schicht Strontium-Wismut-Tantalat (SBT), Blei-Zirkonium-Titanat (PZT), Lithium-Niobat (LiNbO₃) oder Barium-Strontium-Titanat (BST) enthält.

5. Speicherzellenanordnung nach einem der Ansprüche 1 bis 4, bei der der Speichertransistor (ST) ein erstes Source-/Drain-Gebiet (2) aufweist, das mit dem ersten Anschluß (AS1) verbunden ist und das mit der Steuerelektrode (GS) des Speichertransistors (ST) überlappt.

6. Speicherzellenanordnung nach Anspruch 5, bei der der Überlapp zwischen dem ersten Source-/Drain-Gebiet (2) und der Steuerelektrode (GS) des Speichertransistors (ST) mindestens 10 Prozent der Fläche der Steuerelektrode (GS) beträgt.

7. Speicherzellenanordnung nach einem der Ansprüche 1 bis 6, bei der die Kapazität des ferroelektrischen Kondensators und die Kapazität der Steuerelektrode (GS) des Speichertransistors (ST) ein Verhältnis von ungefähr Eins aufweisen.

## Claims

1. Memory cell arrangement
- in which a multiplicity of memory cells each having a selection transistor (AT), a memory transistor (ST) and a ferroelectric capacitor (KE1, FS, KE2) are provided in an integrated manner in a semiconductor substrate (1),
- in which the selection transistor (AT) and the memory transistor (ST) are connected in series via a first terminal (AA1) of the selection transistor (AT),
- in which the ferroelectric capacitor (KE1, FS, KE2) is connected between the first terminal (AA1) of the selection transistor (AT) and a control electrode (GS) of the memory transistor (ST).

2. Memory cell arrangement according to Claim 1,
- in which the selection transistor (AT) and the memory transistor (ST) are each designed as a MOS transistor,
- in which a gate electrode (GA) of the selection transistor (AT) is connected to a word line (WL),
- in which the selection transistor (AT) and the memory transistor (ST) are connected in series between a bit line (BL) and a reference line (RL).

3. Memory cell arrangement according to Claim 2,
- in which the memory transistor (ST) is connected to the reference line (RL) via a first terminal (AS1),
- in which a resistor (R') is connected between the control electrode (GS') of the memory transistor (ST') and the reference line (RL').

4. Memory cell arrangement according to one of Claims 1 to 3,
- in which the ferroelectric capacitor has a first electrode (KE1), a ferroelectric layer (FS) and a second electrode (KE2),
- in which the ferroelectric layer contains strontium bismuth tantalate (SBT), lead zirconium titanate (PZT), lithium niobate (LiNbO₃) or barium strontium titanate (BST).

5. Memory cell arrangement according to one of Claims 1 to 4, in which the memory transistor (ST) has a first source/drain region (2), which is connected to the first terminal (AS1) and overlaps the control electrode (GS) of the memory transistor (ST).

6. Memory cell arrangement according to Claim 5, in which the overlap between the first source/drain region (2) and the control electrode (GS) of the memory transistor (ST) amounts to at least 10% of the area of the control electrode (GS).

7. Memory cell arrangement according to one of Claims 1 to 6, in which the capacitance of the ferroelectric capacitor and the capacitance of the control electrode (GS) of the memory transistor (ST) have a ratio of approximately one.

## Revendications

1. Dispositif de cellules de mémoire,
- dans lequel il est prévu, incorporée à un substrat (1) semi-conducteur, une pluralité de cellules de mémoire qui ont, respectivement, un transistor (AT) de sélection, un transistor (ST) de mémoire et un condensateur (KEln FS, KE2) ferroélectrique,
- dans lequel le transistor (AT) de sélection et le transistor (ST) de mémoire sont câblés en série par une première borne (AA1) du transistor (AT) de sélection,
- dans lequel le condensateur (KE1, FS, KE2) ferroélectrique est monté entre la première borne (AA1) du transistor (AT) de sélection et une électrode (GS) de commande du transistor (ST) de mémoire.

2. Dispositif de cellules de mémoire suivant la revendication 1,
- dans lequel le transistor (AT) de sélection et le transistor (ST) de mémoire sont constitués respectivement sous la forme d'un transistor MOS,
- dans lequel une électrode (GA) de grille du transistor (AT) de sélection est reliée à une ligne (WL) de mot,
- dans lequel le transistor (AT) de sélection et le transistor (ST) de mémoire sont montés en série entre une ligne (BL) de bit et une ligne (RL) de référence.

3. Dispositif de cellules de mémoire suivant la revendication 2,
- dans lequel le transistor (ST) de mémoire est relié à la ligne (RL) de référence par une première borne (AS1),
- dans lequel une résistance (R') est montée entre l'électrode (GS') de commande du transistor (ST') de mémoire et la ligne (RL') de référence.

4. Dispositif de cellules de mémoire suivant l'une des revendications 1 à 3,
- dans lequel le condenseur ferroélectrique a une première électrode (KE1), une couche (FS) ferroélectrique et deuxième électrode (KE2),
- dans lequel la couche ferroélectrique contient du tantalate de strontium et de bismuth (SBT), du titanate de plomb et de zirconium (PZT), du niobate de lithium (LiNbO₃) ou du titanate de baryum et de strontium (BST).

5. Dispositif de cellules de mémoire suivant l'une des revendications 1 à 3, dans lequel le transistor (ST) de mémoire a une première zone (2) de source/drain qui est reliée à la première borne (AS1) et qui est à chevauchement avec l'électrode (GS) de commande du transistor (ST) de mémoire.

6. Dispositif de cellules de mémoire suivant la revendication 5, dans lequel le chevauchement entre la première zone (2) de source/drain et l'électrode (GS) de commande du transistor (ST) de mémoire représente au moins 10 % de la surface de l'électrode (GS) de commande.

7. Dispositif de cellules de mémoire suivant l'une des revendications 1 à 6, dans lequel la capacité du condensateur ferroélectrique et la capacité de l'électrode (GS) de commande du transistor (ST) de mémoire sont dans un rapport d'environ un.
